# EUROPEAN PATENT SPECIFICATION

(11) **EP 2 721 654 B1**
(45) Date of publication and mention of the grant of the patent: **16.11.2016**
(21) Application number: 12801358.8
(22) Date of filing: 15.06.2012
(51) Int. Cl.: H01L 33/20, H01L 33/22, H01L 33/32, H01L 33/00

(54) **SEMICONDUCTOR LIGHT EMITTING DEVICE AND METHOD OF MANUFACTURING THE SAME**
LICHTEMITTIERENDE HALBLEITERVORRICHTUNG UND VERFAHREN ZU IHRER HERSTELLUNG
DISPOSITIF SEMI-CONDUCTEUR ÉMETTANT DE LA LUMIÈRE ET PROCÉDÉ DE FABRICATION DE CELUI-CI

(30) Priority: 15.06.2011 KR 20110058083
(43) Date of publication of application: 23.04.2014
(73) Proprietor: Seoul Viosys Co., Ltd., Gyeonggi-do 425-851 (KR)
(72) Inventor: SUH, Duk II, Ansan-si Gyeonggi-do 425-851 (KR); KIM, Kyoung Wan, Ansan-si Gyeonggi-do 425-851 (KR); YOON, Yeo Jin, Ansan-si Gyeonggi-do 425-851 (KR); KIM, Ye Seul, Ansan-si Gyeonggi-do 425-851 (KR); KIM, Ji Hye, Ansan-si Gyeonggi-do 425-851 (KR)
(74) Representative: Stolmár & Partner Patentanwälte PartG mbB
(86) International application number: PCT/KR2012/004712
(87) International publication number: WO 2012/173416

(56) References cited:
- JP-A- 2009 076 647
- KR-A- 20060 125 079
- KR-A- 20070 041 815
- KR-A- 20100 083 879
- US-A1- 2010 019 251
- US-A1- 2010 081 256
- US-A1- 2010 200 885
- US-A1- 2010 314 633
- US-A1- 2011 062 479

## Description

### [Technical Field]

The present invention relates to a semiconductor light emitting device, and, more particularly, to a semiconductor light emitting device which has superior lateral light extraction efficiency and which allows easy cut of a substrate, and to a method of manufacturing the same.

### [Background Art]

Since the development of nitride semiconductor light emitting devices (e.g. Group 3 nitride semiconductor light emitting devices or laser diodes), they have been receiving attention as a main light source of the next generation in the field of backlights for displays, flashes for cameras, illuminators, etc. As the application field of nitride semiconductor light emitting devices becomes wider, a lot of effort is being directed to increasing luminance and light emission efficiency.

Typically, semiconductor light emitting devices are required to have improved inner quantum efficiency and light extraction efficiency in order to increase light emission efficiency. The inner quantum efficiency is related to properties pertaining to epitaxial growth and the structural design of a substrate, and the light extraction efficiency may be optimized by epitaxial growth and processing techniques.

In particular, it is difficult to increase the light extraction efficiency of the semiconductor light emitting device because light generated from an active layer positioned in the device is totally reflected due to a difference in external refractive index and thus is absorbed or disappears, or such light is absorbed by inner crystal defects and thus converted into heat energy. A critical angle at which light may travel between two media having different refractive indexes may be determined based on the law of refraction (Snells law), and in the case of a nitride-based semiconductor material, its refractive index is as high as about 2.5, and thus, a critical angle at which light produced from the active layer may be emitted outside the device is about 23°, which is very limited. Accordingly in the semiconductor light emitting device, the total reflection of light which is incident on the interface of the device at an angle greater than the critical angle continues until such light is absorbed by the inside of the device, followed by converting the light into heat energy, so that the light extraction efficiency is as low as 30 ~ 40%.

Therefore, research and development into a variety of include grooves formed in a perpendicular direction.

Methods of increasing the light extraction efficiency of semiconductor light emitting devices is ongoing in the art.

Patent document US 2011/062479 discloses a method of manufacturing a group-III nitride semiconductor light-emitting device in which including are an epitaxial step of forming a semiconductor layer (30), a masking step of forming a protective film, a semiconductor layer removal step of removing the protective film, a grinding step of reducing the thickness of the substrate (2), a polishing step of polishing the substrate (2), a laser processing step of providing processing marks to the inside of the substrate (2), and a division step of creating a plurality of light-emitting devices (1) while forming a division surface of the substrate (2) to have a rough surface.

Patent document US 2010/019251 discloses a semiconductor light emitting device comprising a substrate and a light emitting structure. The substrate comprises a plurality of discontinuous fusion spots on at least one side surface thereof. The light emitting structure comprises a plurality of compound semiconductor layers on the substrate.

Patent document US 2010/200885 discloses a light emitting device and a method of fabricating thereof comprising providing a substrate having a first major surface and a second major surface; forming a plurality of light-emitting stacks on the first major surface; forming an etching protection layer on each of the light emitting stacks; forming a plurality of holes by a discontinuous laser beam on the substrate; etching the plurality of holes; and slicing off the substrate along the plurality of holes to form a light emitting device. The light emitting device has a substrate wherein the sidewall of the substrate comprising a first area with a substantially flat surface and a second area with substantially textured surface.

Patent document US 2010/081256 disclose a method for producing a Group III nitride compound semiconductor element which includes growing an epitaxial layer containing a Group III nitride compound semiconductor using a different kind of substrate as an epitaxial growth substrate, adhering a supporting substrate to the top surface of the epitaxial growth layer through a conductive layer, and then removing the epitaxial growth substrate by laser lift-off. Before adhesion of the epitaxial layer and the supporting substrate, a first groove that at least reaches an interface between the bottom surface of the epitaxial layer and the epitaxial growth substrate from the top surface of the epitaxial layer formed on the epitaxial growth substrate and acts as an air vent communicating with the outside of a wafer when the epitaxial layer and the supporting substrate are joined to each other.; Next, the epitaxial layer is divided into each chip by separating the epitaxial growth substrate by laser lift-off, and then removing the epitaxial layer serving as the outer periphery of each chip. Next, the outer peripheral side surface of the epitaxial layer of each chip is at least completely covered with an insulating protective film. Next, the supporting substrate is separated into each chip.

### BRIEF SUMMARY OF THE INVENTION

The above-mentioned problems are solved by the teaching of the independent claims.

The present invention has been made keeping in mind the above problems occurring in the related art, and the present invention is intended to provide a semiconductor light emitting device which is capable of increasing lateral light extraction efficiency.

In addiction, the present invention is intended to provide a method of manufacturing the semiconductor light emitting device.

Therefore, an aspect of the present invention provides a semiconductor light emitting device, comprising a sapphire substrate; and a light emitting structure formed on an upper surface of the sapphire substrate, the light emitting structure comprising a plurality of nitride epitaxial layers including an active layer which produces light, wherein at least one side surface of the light emitting structure is formed as an inclined surface which creates an acute angle relative to the upper surface of the sapphire substrate.

In this aspect, an irregular pattern may be formed on the upper surface of the sapphire substrate.

In this aspect, the side surface of the light emitting structure, which is formed as the inclined surface, may

In this aspect, at least one side surface of the sapphire substrate may include at least one modification region in a band shape formed in a horizontal direction.

In this aspect, the modification region may be formed by radiating a laser at a predetermined interval in a horizontal direction onto an upper portion or a lower portion of the semiconductor light emitting device. Also, the modification region may be formed at a position at least 30 µm spaced apart from the upper surface of the substrate having the nitride structure. Also, when the at least one modification region may comprise a plurality of modification regions, the modification regions may be spaced apart from each other by an interval of 40 ~ 90 µm. Also, the laser may be a femto-second or pico-second pulse laser using an infrared source.

In this aspect, the light emitting structure may comprise an n-type nitride semiconductor layer, the active layer, and a p-type nitride semiconductor layer, which are sequentially formed on the upper surface of the sapphire substrate, and may include a hole which is formed at a predetermined distance from the side surface of the light emitting structure so as to expose part of an upper surface of the n-type nitride semiconductor layer. Also, the light emitting structure may further comprise an n-electrode formed on the upper surface of the n-type nitride semiconductor layer exposed by the hole.

In addition, the present invention provides a method of manufacturing a semiconductor light emitting device, comprising forming a light emitting structure comprising a plurality of nitride epitaxial layers including an active layer which produces light on an upper surface of a sapphire substrate, removing a partial region of the light emitting structure thus exposing a predetermined region of the sapphire substrate, and wet etching a side surface of the light emitting structure defined by the exposed region of the sapphire substrate, thus forming an inclined surface which creates an acute angle relative to the upper surface of the sapphire substrate.

In this aspect, the method may further comprise separating the sapphire substrate into discrete unit devices thus forming discrete semiconductor light emitting devices. Also, forming the discrete semiconductor light emitting devices may be carried out in such a manner that a laser which is focused on at least one height inside the sapphire substrate is radiated multiple times at a predetermined interval along a separation surface where the discrete devices are separated from the upper surface or lower surface of the sapphire substrate, thus dividing the sapphire substrate. Also, the height of the focused laser may be a position at least 30 µm spaced apart from the upper surface of the sapphire substrate having the plurality of nitride epitaxial layers. Also, when the at least one height of the focused laser may comprise a plurality of heights, the heights may be positioned separated by an interval of 40 ~ 90 µm. Also, the laser may be a femto-second or pico-second pulse laser using an infrared source.

In this aspect, an irregular pattern may be formed on the upper surface of the sapphire substrate.

In this aspect, removing the partial region of the light emitting structure may be carried out using dry etching or laser irradiation.

In this aspect, forming the light emitting structure may be carried out by sequentially forming an n-type nitride semiconductor layer, the active layer, and a p-type nitride semiconductor layer on the upper surface of the sapphire substrate thus forming the light emitting structure. Also, removing part of the active layer and the p-type nitride semiconductor layer at a position spaced apart from the side surface of the light emitting structure so as to expose part of the upper surface of the n-type nitride semiconductor layer thus forming a hole, and forming an n-electrode on the upper surface of the n-type nitride semiconductor layer exposed by the hole may be further performed.

### [Advantageous Effects]

According to the present invention, at least one side surface of a light emitting structure of a semiconductor light emitting device is formed as an inclined surface, thereby effectively increasing light extraction efficiency in a lateral direction of the light emitting structure. Furthermore, grooves can be formed in a perpendicular direction on the side surface of the light emitting structure, thus further increasing the light extraction efficiency.

Also according to the present invention, at least one modification region can be formed on at least one side surface of a sapphire substrate of a semiconductor light emitting device to provide irregularities, so that light extraction efficiency can also be increased in a lateral direction of the substrate.

Also according to the present invention, a laser can be radiated at a variety of different heights, whereby a thick sapphire substrate can be easily separated.

### [Description of Drawings]

FIG. 1 is a perspective view illustrating a semiconductor light emitting device according to an embodiment of the present invention;
FIG. 2 is a side view illustrating one side surface of the semiconductor light emitting device of FIG. 1;
FIGS. 3 and 4 are side views illustrating one side surface of a semiconductor light emitting device according to a variety of embodiments of the present invention;
FIGS. 5a to 5d are views illustrating the formation of the modification region formed on a sapphire substrate of the semiconductor light emitting device according to the embodiment of the present invention;
FIGS. 6a to 6e are cross-sectional views illustrating a process of manufacturing the semiconductor light emitting device according to an embodiment of the present invention;
FIG. 7 is a scanning electron microscope (SEM) image illustrating one side surface of the semiconductor light emitting device according to the embodiment of the present invention;
FIGS. 8a and 8b are electron microscope images illustrating a top plan view of the semiconductor light emitting device according to the embodiment of the present invention;
FIG. 9 is an image illustrating a side view of the light emitting structure of the semiconductor light emitting device according to the embodiment of the present invention;
FIGS. 10a and 10b are images illustrating the light emission distribution of the semiconductor light emitting device according to the embodiment of the present invention and a typical semiconductor light emitting device.

### [Mode for Invention]

Hereinafter, preferred embodiments of the present invention will be described in detail with reference to the accompanying drawings. however, the embodiments of the present invention may be modified into a variety of different forms, and the scope of the present invention is not limited thereto. The embodiments of the present invention are provided to allow the present invention to be more clearly understood by those having ordinary knowledge in the art. Further, in the description of the present invention, the terms defined in consideration of functions in the present invention may vary depending on the usage or intention of technicians who work in the art, and should not be construed as meanings which limit the technical elements of the present invention.

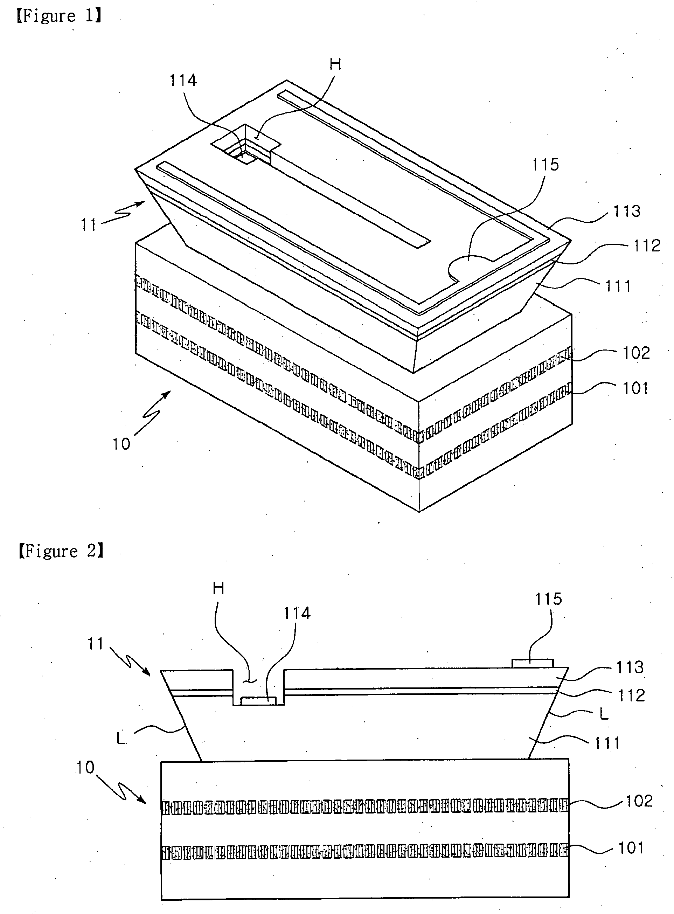

FIG. 1 is a perspective view illustrating a semiconductor light emitting device according to an embodiment of the present invention, and FIG. 2 is a side view illustrating one side surface of the semiconductor light emitting device of FIG. 1.

With reference to FIGS. 1 and 2, the semiconductor light emitting device according to the embodiment of the present invention comprises a sapphire substrate 10, and a light emitting structure 11 formed on the upper surface of the sapphire substrate.

The sapphire substrate 10 is applied taking into consideration the lattice matching with a nitride epitaxial layer material which is grown thereon. The sapphire substrate is a crystal body having Hexa-Rhombo (Hexa-Rhombo R3c) symmetry, and has a lattice constant of 13.001 A in c-axis orientation, and a lattice constant of 4.758 A in a-axis orientation; and has a C-plane (0001), an A-plane (1120), an R-plane (1102), etc. The C-plane of this sapphire substrate allows a nitride thin film to be grown thereupon relatively easily and is stable even at high temperatures, thus it is predominantly utilized as a substrate for a blue or green light emitting device.

The light emitting structure 11 is formed on the upper surface of the sapphire substrate 10, and may include a light emitting structure comprising a plurality of nitride epitaxial layers including an active layer 112 which produces light. The semiconductor light emitting device according to the embodiment of the present invention is configured such that at least one side surface L of the light emitting structure 11 is formed as an inclined surface which creates an acute angle relative to the upper surface of the sapphire substrate 10.

When the side surface of the light emitting structure 11 is formed as an inclined surface which creates an acute angle relative to the upper surface of the substrate 10 in this way, the incident angle of light which is incident on the side surface of the light emitting structure 11 may be set to be smaller than the critical angle for outer emission which is determined based on the law of refraction, in the light emitting structure. Thereby the amount of light emitted in the lateral direction of the light emitting structure 11 may become larger, thus increasing light extraction efficiency.

The light emitting structure 11 may include an n-type nitride semiconductor layer 111, an active layer 112, and a p-type nitride semiconductor layer 113.

The n-type nitride semiconductor layer 111 is formed with n-type AlₓIn_{y}Ga_{1-x-y}N(0≤x,y,x+y≤1), and may be composed of a nitride semiconductor doped with an n-type impurity. For example, a nitride semiconductor such as GaN, AlGaN or InGaN may be doped with an impurity such as Si, Ge, Se, Te or C.

The active layer 112 is a region where electrons and holes are recombined to emit light, and the wavelength of extracted light is determined depending on the kind of material of the active layer 112. The active layer 112 may have a multiple quantum well (MQW) structure or a single quantum well structure, and a barrier layer and a well layer are a binary compound semiconductor layer to a quaternary compound semiconductor layer represented by AlₓIn_{y}Ga_{1-x-y}N(0≤x,y,x+y≤1). For example, an InGaN layer is grown as the well layer, and the GaN layer is grown as the barrier layer thus forming MQW.

The p-type nitride semiconductor layer 113 is formed with p-type AlₓIn_{y}Ga_{1-x-y}N(0≤x,y,x+y≤1), and may be composed of a semiconductor material doped with a p-type impurity. For example, a nitride semiconductor such as GaN, AlGaN or InGaN may be doped with an impurity such as Mg, Zn or Be.

Typically, the semiconductor light emitting device may include an n-electrode 114 and a p-electrode 115 respectively electrically connected to the n-type nitride semiconductor layer and the p-type nitride semiconductor layer in order to apply a driving voltage and allow inflow of a driving current. In a horizontal type semiconductor light emitting device, the n-electrode may be formed on the n-type nitride semiconductor exposed by removing part of the active layer 112 and the p-type nitride semiconductor layer 113.

According to the embodiment of the present invention, the light emitting structure 11 may include a hole H which is formed at predetermined distances from the side surfaces of the light emitting structure so as to expose part of the upper surface of the n-type nitride semiconductor layer. The n-electrode 114 may be formed on the upper surface of the n-type nitride semiconductor layer 111 exposed by the hole H. The hole H which plays a role in forming a region where the n-electrode is provided is formed at predetermined distances from the side surfaces which are provided in the form of an inclined surface, thereby preventing the deformation of such side surfaces. Consequently, the effect of increasing light extraction efficiency, which may be obtained by forming the side surfaces as an inclined surface, may be prevented from decreasing.

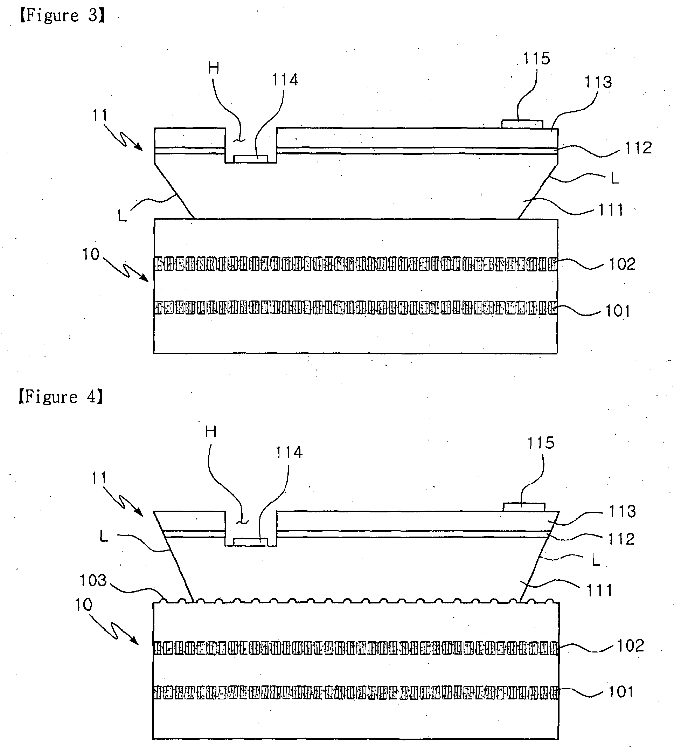

FIGS. 3 and 4 are side views illustrating one side surface of the semiconductor light emitting device according to a variety of embodiments of the present invention.

FIG. 3 illustrates an inclined surface L formed at the lower portion of the side surface of the light emitting structure 11 which is located close to the sapphire substrate 10, and FIG. 4 illustrates an irregular pattern 103 formed on the upper surface of the sapphire substrate 10.

As illustrated in FIG. 3, in the case where the side surface of the light emitting structure 11 is formed as an inclined surface which creates an acute angle relative to the upper surface of the sapphire substrate 10, the light produced from the active layer 112, in particular, light traveling towards the n-type nitride semiconductor layer 111 positioned under the active layer 112, has a much smaller incident angle.

Also as illustrated in FIG. 4, light produced from the active layer 112 is scattered by the irregular pattern 103 formed on the upper surface of the sapphire substrate 10, thus increasing the probability of light being emitted to the outside of the light emitting device to thereby enhance light extraction efficiency. In the embodiment of FIG. 4, comparatively more defects occur in the light emitting structure close to the sapphire substrate 10 due to the irregular pattern 103 formed on the upper surface of the sapphire substrate 10. Because such defects may weaken the molecular bonding structure, in a wet etching process which is used to form a side surface of the light emitting structure 11 into an inclined surface, the etched amount of the region near the sapphire substrate 10 becomes larger thus increasing the gradient. Furthermore, because of a difference in the etched amount between the region having the irregular pattern 103 and the region having no pattern, a plurality of grooves may be formed in a perpendicular direction on the inclined side surface of the light emitting structure 11. These grooves may further increase the light extraction efficiency in the lateral direction of the light emitting structure 11.

In the embodiments illustrated in FIGS. 1 to 4, one or more modification regions 101, 102-may be formed on at least one side surface of the sapphire substrate 10.

The modification regions 101, 102 may be formed by a laser which is radiated in a horizontal direction at predetermined heights inside a wafer, in the course of separating the sapphire substrate in a wafer state. Specifically in FIGS. 1 to 4, the modification regions 101, 102 may be formed by focusing a laser on the corresponding height in the upper or lower portion of the sapphire substrate in a wafer state and radiating such a laser multiple times in a horizontal direction.

The laser which is focused and radiated to the inside of the sapphire substrate 10 may be a femto-second pulse laser or a pico-second pulse laser using an infrared source. The femto-second pulse laser or the pico-second pulse laser using the infrared source may use less filter than an infrared source laser, thus enabling much stronger inner processing and non-thermal processing in a short period of time thereby reducing damage to the device.

In the course of separating the sapphire substrate in a wafer state by the laser to form discrete devices, the laser is radiated onto a separation surface where the discrete devices are separated. After completion of the separation of discrete devices by the laser, the modification regions 101, 102 may be formed on the separation surface.

The modification regions 101, 102 may be formed in a band shape in a horizontal direction on the side surface of the substrate by way of laser irradiation which is performed at a predetermined interval in the horizontal direction of the device.

The modification regions 101, 102 may form irregularities on the side surface of the sapphire substrate 10, so that the inner total reflection of light which is emitted from the inside of the sapphire substrate 10 to the outside thereof may decrease, thereby increasing the light extraction efficiency in the lateral direction of the device.

The number of modification regions 101, 102 may vary depending on the thickness of the sapphire substrate 10.

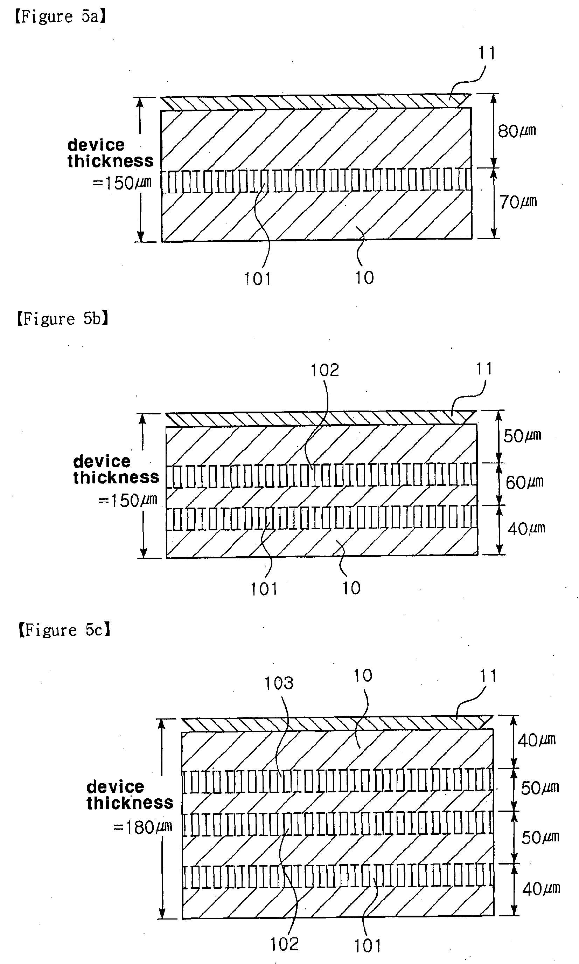

FIGS. 5a to 5d illustrate the formation of the modification regions on the sapphire substrate of the semiconductor light emitting device according to the embodiment of the present invention.

As illustrated in FIGS. 5a and 5b, in the device having a total thickness of 150 µm, a laser is focused at a height of 70 µm from the lower surface of the sapphire substrate 10 and then radiated to form a single modification region 101, or is focused at heights of 40 µm and 100 µm from the lower surface of the sapphire substrate 10 and then radiated to form two modification regions 101, 102.

As illustrated in FIG. 5c, in the device having a total thickness of 180 µm, a laser is focused at heights of 40 µm, 90 µm and 140 µm from the lower surface of the sapphire substrate 10 and then radiated to form three modification regions 101, 102, 103.

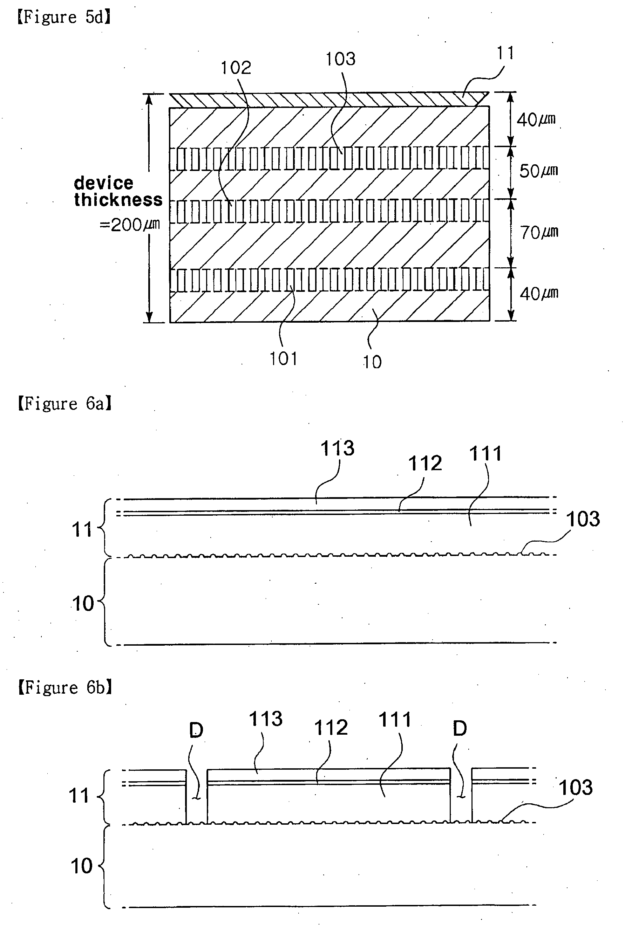

Also as illustrated in FIG. 5d, in the device having a total thickness of 200 µm, a laser is focused at heights of 40 µm, 110 µm and 160 µm from the lower surface of the sapphire substrate 10 and then radiated to form three modification regions 101, 102, 103.

According to the embodiment of the present invention, the positions at which a laser is radiated are appropriately adjusted to form modification regions, which may be applied to the separation of a device having different thicknesses. In this procedure, in order to prevent damage to the light emitting structure 11 formed on the sapphire substrate 10, the modification region is preferably formed at a position at least 30 µm spaced apart from the upper surface of the sapphire substrate 10 on which the light emitting structure 11 is formed. Furthermore, in the case where a plurality of modification regions is formed taking into consideration the easy separation of the sapphire substrate and the number of times of irradiation with the laser, respective modification regions may be spaced apart from each other by an interval of 40 ~ 90 µm.

FIGS. 6a to 6e are cross-sectional views illustrating a process of manufacturing the semiconductor light emitting device according to an embodiment of the present invention.

As illustrated in FIG. 6a, the method of manufacturing the semiconductor light emitting device according to the embodiment of the present invention begins from sequentially forming the n-type nitride semiconductor layer 111, the active layer 112 and the p-type nitride semiconductor layer 113 on the upper surface of the sapphire substrate 10 to form the light emitting structure 11. FIGS. 6a to 6e illustrate the use of the sapphire substrate 10 having an irregular pattern 103 formed thereon but the present invention is not limited thereto.

Subsequently, as illustrated in FIG. 6b, the partial regions D of the light emitting structure 11 are removed thus exposing predetermined regions of the sapphire substrate 10. The regions D of the light emitting structure 11 may be used when separating the device into discrete unit devices. The procedure of removing the partial regions of the light emitting structure 11 may be carried out by removing the light emitting structure 11 using dry etching or laser irradiation.

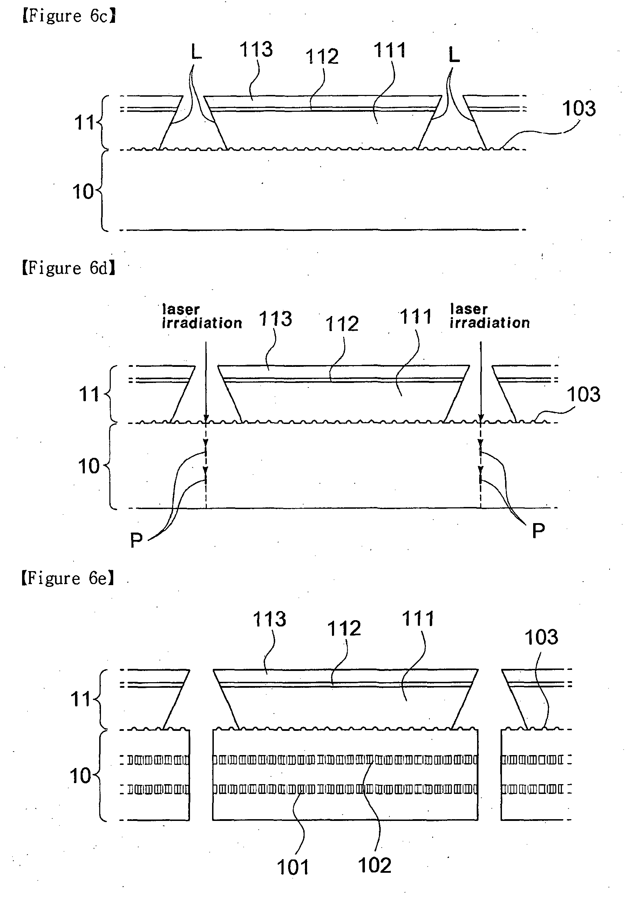

Subsequently, as illustrated in FIG. 6c, the side surfaces of the light emitting structure 11 defined by the exposed regions of the sapphire substrate 10 are wet etched, thus forming inclined surfaces which create an acute angle relative to the upper surface of the sapphire substrate. In this wet etching process, hydroxide (e.g. potassium hydroxide or sodium hydroxide) and an acid-based material (e.g. sulfuric acid, phosphoric acid, nitric acid and mixtures thereof) may be used as an etchant. When the wet etching process is performed in this way, the light emitting structure is etched in a larger amount as it becomes closer to the sapphire substrate which has a comparatively unstable molecular bonding structure, and is etched in a smaller amount as it becomes more distant from the substrate, whereby the side surfaces of the light emitting structure may be formed as inclined surfaces.

Subsequently, in order to separate into discrete unit devices, as illustrated in FIG. 6d, a focused laser may be radiated onto specific positions P inside the sapphire substrate 10. The procedure illustrated in FIG. 6d is carried out in such a manner that a laser focused on at least one height P inside the sapphire substrate 10 is radiated multiple times at predetermined intervals along the separation surface where discrete unit devices are separated from the upper surface or lower surface of the sapphire substrate 10, so that the sapphire substrate is divided. When the inside of the sapphire substrate 10 is irradiated with the focused laser in this way, the modification regions may be formed on the side surfaces of the sapphire substrate of the discrete unit devices.

As illustrated in FIG. 6e after the procedures of FIGS. 6a to 6d, the modification regions 101, 102 are formed on the side surfaces of the sapphire substrate 10, and the side surfaces of the light emitting structure 11 may be formed as inclined surfaces which create an acute angle relative to the upper surface of the sapphire substrate 10.

Although not shown, the method of manufacturing the semiconductor light emitting device according to the embodiment of the present invention may further comprise forming n-electrodes and p-electrodes of discrete unit devices.

For example, before the sapphire substrate 10 is separated into discrete unit devices by the procedure illustrated in FIG. 6d, electrodes may be formed. In particular, forming the n-electrode may be carried out by removing part of the active layer 112 and the p-type nitride semiconductor layer 113 at a position spaced apart from the side surfaces of the light emitting structure so as to expose part of the upper surface of the n-type nitride semiconductor layer 111 thus forming a hole (H in FIGS. 1 to 4), and forming the n-electrode (114 in FIGS. 1 to 4) on the upper surface of the n-type nitride semiconductor layer 111 exposed by the hole.

Below is a description of the effects of the present invention made through the actual images of the semiconductor light emitting device according to the embodiment of the present invention.

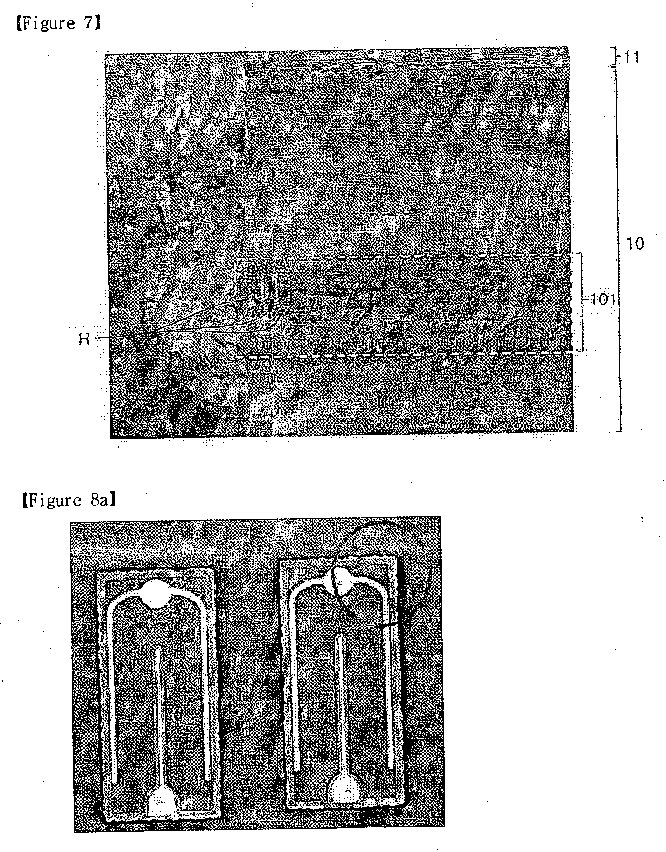

FIG. 7 is an SEM image illustrating one side surface of the semiconductor light emitting device according to the embodiment of the present invention.

As seen in FIG. 7, the reference numeral 10 designates the substrate, and the reference numeral 11 designates the light emitting structure, and the reference numeral 101 designates the modification region. As mentioned above, the modification region 101 is formed in such a manner that a femto-second laser or a pico-second laser using an infrared source is radiated multiple times at a predetermined interval in a horizontal direction onto the upper or lower surface of the substrate 10. In FIG. 7, the portion represented by R indicates a region on which a laser is directly radiated, and the modification region in which the properties of sapphire are different is formed by absorbing energy of the laser around the region irradiated with the laser. The modification region formed in the substrate by way of laser irradiation is exposed on the side surfaces of the separated discrete devices. The random irregular shape of the modification region enables the incident angle of light which is incident on the modification region in the device to vary to thus reduce the inner total reflection thereof thereby increasing the lateral light extraction efficiency of the sapphire substrate.

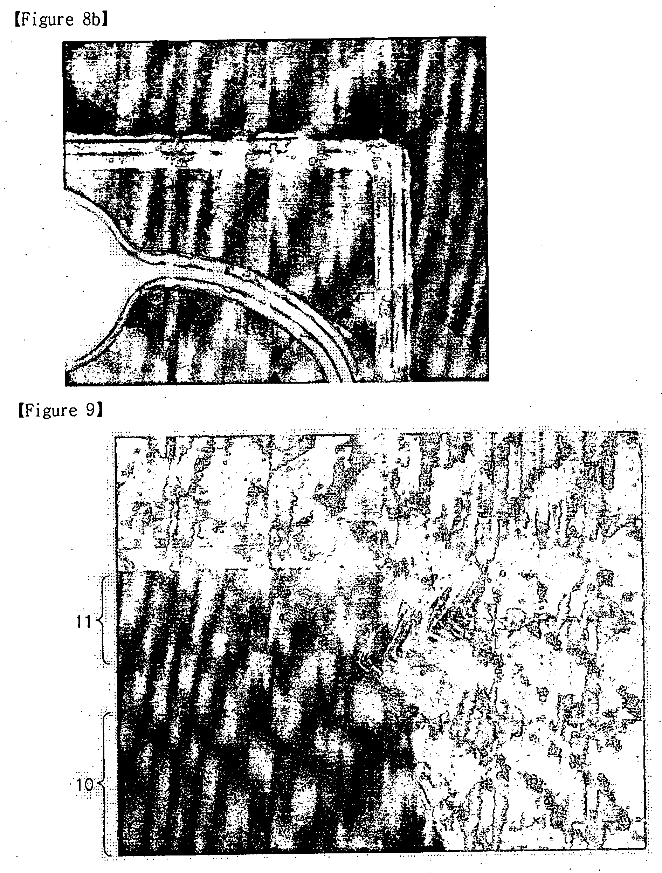

FIGS. 8a and 8b are electron microscope images showing a top plan view of the semiconductor light emitting device according to the embodiment of the present invention, and FIG. 9 is an electron microscope image showing a side view of the light emitting structure of the semiconductor light emitting device according to the embodiment of the present invention.

As illustrated in FIGS. 8a, 8b and 9, the side surfaces of the light emitting structure 11 may be formed as inclined surfaces using wet etching, and grooves having a non-uniform shape may be formed in a perpendicular direction due to a difference in the amount of etching. The side surfaces of the light emitting structure may include random irregularities due to such grooves, and these irregularities enable the incident angle of light which is incident in the lateral direction of the device to vary thus reducing the inner total reflection and increasing the lateral light extraction efficiency.

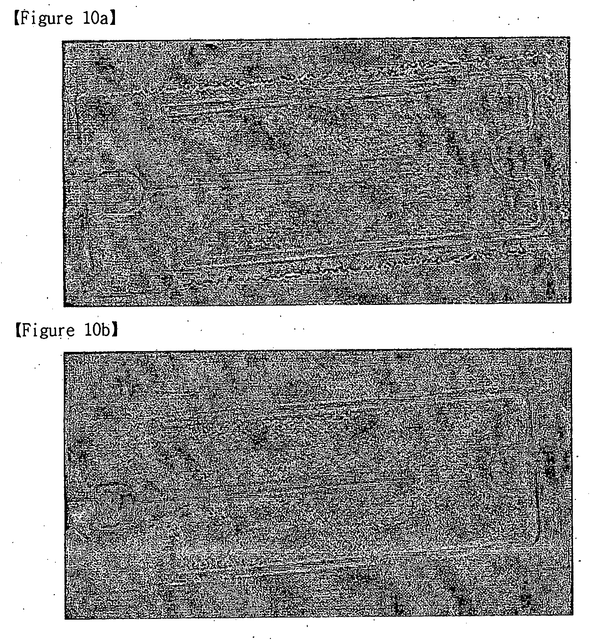

FIGS. 10a and 10b illustrate the light emission distribution of the semiconductor light emitting device according to the embodiment of the present invention and a typical semiconductor light emitting device.

As illustrated in FIG. 10a, the semiconductor light emitting device according to the embodiment of the present invention can be seen to achieve a large amount of light emission from the side surfaces of the light emitting device. However, it can be seen that the typical semiconductor light emitting device illustrated in FIG. 10b exhibits very weak lateral light emission.

As described above, the side surfaces of the light emitting structure of the semiconductor light emitting device according to embodiments of the present invention are formed as inclined surfaces, thus increasing light extraction efficiency in the lateral direction of the light emitting structure. In particular, grooves are formed in a perpendicular direction on the side surfaces of the light emitting structure thus further increasing the light extraction efficiency. Also according to one embodiment of the present invention, modification regions are formed on the side surfaces of the sapphire substrate of the semiconductor light emitting device to provide irregularities, thus increasing the light extraction efficiency in the lateral direction of the substrate. Moreover, according to one embodiment of the present invention, when the sapphire substrate is separated, a laser can be radiated at different heights thus enabling a thick sapphire substrate to be easily divided.

Although the preferred embodiments of the present invention have been disclosed for illustrative purposes, those skilled in the art will appreciate that various modifications, additions and substitutions are possible, without departing from the scope of the invention as disclosed in the accompanying claims.

## Claims

1. A semiconductor light emitting device, comprising:
a sapphire substrate (10); and
a light emitting structure (11) disposed on an upper surface of the sapphire substrate, the light emitting structure comprising a plurality of nitride epitaxial layers (111-113) including an active layer (112) which produces light,
wherein at least one side surface of the light emitting structure (11) is formed as an inclined surface which creates an acute angle relative to the upper surface of the sapphire substrate (10), **characterised in that**
the side surface of the light emitting structure (11), which is formed as the inclined surface, includes grooves formed in a perpendicular direction, and wherein the grooves increase light extraction efficiency in a lateral direction of the light emitting structure.

2. The semiconductor light emitting device of claim 1, wherein an irregular pattern is formed on the upper surface of the sapphire substrate.

3. The semiconductor light emitting device of claim 1 or 2, wherein at least one side surface of the sapphire substrate includes at least one modification region in a band shape formed in a horizontal direction.

4. The semiconductor light emitting device of claim 3, wherein the modification region is formed by radiating a laser at a predetermined interval in a horizontal direction onto an upper portion or a lower portion of the semiconductor light emitting device.

5. The semiconductor light emitting device of claim 3, wherein the modification region is formed at a position at least 30 µm spaced apart from the upper surface of the substrate having a nitride structure.

6. The semiconductor light emitting device of claim 3, wherein when the at least one modification region comprises a plurality of modification regions, the modification regions are spaced apart from each other by an interval of 40 ~ 90 µm.

7. The semiconductor light emitting device of claim 4, wherein the laser is a femto-second or pico-second pulse laser using an infrared source.

8. The semiconductor light emitting device of claim 1, wherein the light emitting structure comprises an n-type nitride semiconductor layer, the active layer, and a p-type nitride semiconductor layer, which are sequentially formed on the upper surface of the sapphire substrate, and includes a hole which is formed at a predetermined distance from the side surface of the light emitting structure so as to expose part of an upper surface of the n-type nitride semiconductor layer, and
the light emitting structure further comprises an n-electrode formed on the upper surface of the n-type nitride semiconductor layer exposed by the hole.

9. A method of manufacturing a semiconductor light emitting device, comprising:
forming a light emitting structure comprising a plurality of nitride epitaxial layers including an active layer which produces light on an upper surface of a sapphire substrate;
removing a partial region of the light emitting structure thus exposing a predetermined region of the sapphire substrate; and
wet etching a side surface of the light emitting structure defined by the exposed region of the sapphire substrate, thus forming an inclined surface which creates an acute angle relative to the upper surface of the sapphire substrate and forming grooves in the inclined surface in a perpendicular direction,
wherein the grooves increase light extraction efficiency in a lateral direction of the light emitting structure.

10. The method of claim 9, further comprising separating the sapphire substrate into discrete unit devices thus forming discrete semiconductor light emitting devices.

11. The method of claim 10, wherein the forming the discrete semiconductor light emitting devices is carried out in such a manner that a laser which is focused on at least one height inside the sapphire substrate is radiated multiple times at a predetermined interval along a separation surface where the discrete devices are separated from the upper surface or lower surface of the sapphire substrate, thus dividing the sapphire substrate.

12. The method of claim 11, wherein the height of the focused laser is a position at least 30 µm spaced apart from the upper surface of the sapphire substrate having the plurality of nitride epitaxial layers.

13. The method of claim 11, wherein when the at least one height of the focused laser comprises a plurality of heights, the heights are positioned separated by an interval of 40 ~ 90 µm.

14. The method of claim 11, wherein the laser is a femto-second or pico-second pulse laser using an infrared source.

15. The method of claim 9, wherein an irregular pattern is formed on the upper surface of the sapphire substrate.

16. The method of claim 9, wherein the removing the partial region of the light emitting structure is carried out using dry etching or laser irradiation.

17. The method of claim 9, wherein the forming the light emitting structure is. carried out by sequentially forming an n-type nitride semiconductor layer, the active layer, and a p-type nitride semiconductor layer on the upper surface of the sapphire substrate, thus forming the light emitting structure, and further comprises removing part of the active layer and the p-type nitride semiconductor layer at a position spaced apart from the side surface of the light emitting structure so as to expose part of an upper surface of the n-type nitride semiconductor layer, thus forming a hole, and forming an n-electrode on the upper surface of the n-type nitride semiconductor layer exposed by the hole.

## Patentansprüche

1. Halbleiter-Leuchtgerät, umfassend:
ein Saphirsubstrat (10); und
eine Leuchtstruktur (11), angebracht auf einer oberen Oberfläche des Saphirsubstrats, die Leuchtstruktur umfassend eine Vielzahl von epitaktischen Nitrid-Schichten (111-113) einschließlich einer aktiven Schicht (112), die Licht produziert,
wobei mindestens eine Seitenoberfläche der Leuchtstruktur (11) ausgebildet ist als eine geneigte Oberfläche, die einen spitzen Winkel relativ zur oberen Oberfläche des Saphirsubstrats (10) bildet, **dadurch gekennzeichnet, dass**
die Seitenoberfläche der Leuchtstruktur (11), die als geneigte Oberfläche ausgebildet ist, Rillen in einer senkrechten Richtung umfasst und wobei die Rillen die Lichhtextraktionseffizienz in einer seitlichen Richtung der Leuchtstruktur erhöhen.

2. Halbleiter-Leuchtgerät gemäß Anspruch 1, wobei ein unregelmäßiges Muster auf der oberen Oberfläche des Saphirsubstrats ausgebildet ist.

3. Halbleiter-Leuchtgerät gemäß Anspruch 1 oder 2, wobei mindestens eine Seitenoberfläche des Saphirsubstrats mindestens einen Modifizierungsbereich in Bandform, ausgebildet in einer horizontalen Richtung, umfasst.

4. Halbleiter-Leuchtgerät gemäß Anspruch 3, wobei der Modifizierungsbereich ausgebildet wird durch Bestrahlen mit einem Laser in einem vorgegebenen Intervall in einer horizontalen Richtung auf einem oberen Teil oder einem unteren Teil des Halbleiter-Leuchtgeräts.

5. Halbleiter-Leuchtgerät gemäß Anspruch 3, wobei der Modifizierungsbereich an einer Position, die mindestens 30 µm von der oberen Oberfläche des Substrats mit Nitridstruktur entfernt ist, ausgebildet ist.

6. Halbleiter-Leuchtgerät gemäß Anspruch 3, wobei, wenn der mindestens eine Modifizierungsbereich eine Vielzahl von Modifizierungsbereichen umfasst, die Modifizierungsbereiche voneinander durch einen Zwischenraum von 40 ~ 90 µm getrennt sind.

7. Halbleiter-Leuchtgerät gemäß Anspruch 4, wobei der Leser ein Femto-Sekunden-oder Pico-Sekunden-Pulslaser, der eine Infrarotquelle verwendet, ist.

8. Halbleiter-Leuchtgerät gemäß Anspruch 1, wobei die Leuchtstruktur eine Nitrid-Halbleiterschicht vom n-Typ umfasst, die aktive Schicht, und eine Nitrid-Halbleiterschicht vom p-Typ, die nacheinander auf der oberen Oberfläche des Saphirsubstrats ausgebildet werden, und ein Loch umfasst, das in einem vorbestimmten Abstand von der Seitenoberfläche der Leuchtstruktur ausgebildet ist, sodass ein Teil der oberen Oberfläche der Nitrid-Halbleiterschicht vom n-Typ freigelegt ist, und die Leuchtstruktur weiterhin eine n-Elektrode umfasst, die auf der oberen Oberfläche der Nitrid-Halbleiterschicht vom n-Typ, die durch das Loch freigelegt wird, ausgebildet wird.

9. Verfahren zum Herstellen eines Halbleiter-Leuchtgeräts, umfassend
Ausbilden einer Leuchtstruktur, umfassend eine Vielzahl von epitaktischen Nitrid-Schichten einschließlich einer aktiven Schicht, die Licht produziert, auf einer oberen Oberfläche eines Saphirsubstrats;
Entfernen eines Teilbereichs der Leuchtstruktur, dadurch Freilegen eines vorbestimmten Bereichs des Saphirsubstrats; und
Nassätzen einer Seitenoberfläche der Leuchtstruktur, die durch den freigelegten Bereich des Saphirsubstrats eingegrenzt wird, dadurch Ausbilden einer geneigten Oberfläche, die einen spitzen Winkel relativ zur oberen Oberfläche des Saphirsubstrats bildet, und Ausbilden von Rillen in der geneigten Oberfläche in einer senkrechten Richtung,
wobei die Rillen die Lichtextraktionseffizienz in einer seitlichen Richtung der Leuchtstruktur erhöhen.

10. Verfahren gemäß Anspruch 9, weiter umfassend Aufteilen des Saphirsubstrats in diskrete Einheitsgeräte, dadurch Ausbilden von diskreten Halbleiter-Leuchtgeräten.

11. Verfahren gemäß Anspruch 10, wobei das Ausbilden der diskreten Halbleiter-Leuchtgeräte auf eine solche Weise durchgeführt wird, dass ein Laser, der auf mindestens eine Höhe innerhalb des Saphirsubstrats fokussiert ist, mehrere Male in einem vorbestimmten Intervall entlang einer Trennflächen gestrahlt wird, wo die diskreten Geräte von der oberen Oberfläche oder der unteren Oberfläche des Saphirsubstrats abgetrennt werden, dadurch Teilen des Saphirsubstrats.

12. Verfahren gemäß Anspruch 11, wobei die Höhe des fokussierten Lasers in einer Position, die mindestens 30 µm von der oberen Oberfläche des Saphirsubstrats, das eine Vielzahl von epitaktischen Nitrid-Schichten hat, entfernt ist.

13. Verfahren gemäß Anspruch 11, wobei, wenn die mindestens eine Höhe des fokussierten Lasers eine Vielzahl von Höhen umfasst, die Höhen durch ein Intervall von 40-90 µm getrennt positioniert sind.

14. Verfahren gemäß Anspruch 11, wobei der Laser ein Femto-Sekunden-oder Pico-Sekunden-Pulslaser, der eine Infrarotquelle verwendet, ist.

15. Verfahren gemäß Anspruch 9, wobei ein unregelmäßiges Muster auf der oberen Oberfläche des Saphirsubstrats ausgebildet ist.

16. Verfahren gemäß Anspruch 9, wobei das Entfernen des Teilbereichs der Leuchtstruktur mittels Trockenätzen oder Laserbestrahlung durchgeführt wird.

17. Verfahren gemäß Anspruch 9, wobei das Ausbilden der Leuchtstruktur durchgeführt wird durch fortlaufendes Ausbilden einer Nitrid-Halbleiterschicht vom n-Typ, der aktiven Schicht, und einer Nitrid-Halbleiterschicht vom p-Typ auf der oberen Oberfläche des Saphirsubstrats, dadurch Ausbilden der Leuchtstruktur, und weiter umfasst Entfernen eines Teils der aktiven Schicht und der Nitrid-Halbleiterschicht vom p-Typ an einer Position, die von der Seitenoberfläche der Leuchtstruktur entfernt ist, sodass ein Teil der oberen Oberfläche der Nitrid-Halbleiterschicht vom n-Typ freigelegt wird, dadurch Ausbilden eines Lochs, und Ausbilden einer n-Elektrode auf der oberen Oberfläche der Nitrid-Halbleiterschicht vom n-Typ, die durch das Loch freigelegt wird.

## Revendications

1. Un dispositif semi-conducteur électroluminescent, comprenant:
un substrat en saphir (10); et
une structure émettrice de lumière (11) disposée sur une surface supérieure du substrat en saphir, la structure émettrice de lumière comprenant une pluralité de couches épitaxiales de nitrure (111-113) comprenant une couche active (112) qui produit de la lumière,
dans lequel au moins une surface latérale de la structure émettrice de lumière (11) est formée comme une surface inclinée qui crée un angle aigu par rapport à la surface supérieure du substrat en saphir (10),
**caractérisé en ce que**
la surface latérale de la structure émettrice de lumière (11), qui est formée comme surface inclinée, comporte des rainures formées dans une direction perpendiculaire, et dans lequel les rainures augmentent le rendement d'extraction de lumière dans une direction latérale de la structure émettrice de lumière.

2. Le dispositif semi-conducteur électroluminescent selon la revendication 1, dans lequel un motif irrégulier est formé sur la surface supérieure du substrat en saphir.

3. Le dispositif semi-conducteur électroluminescent selon la revendication 1 or 2, dans lequel au moins one surface latérale du substrat en saphir comporte au moins une zone de modification en forme de bande formée dans une direction horizontale.

4. Le dispositif semi-conducteur électroluminescent selon la revendication 3, dans lequel la zone de modification est formée par un rayonnement laser à un intervalle prédéterminé dans une direction horizontale sur une partie supérieure ou sur une partie inférieure du dispositif semi-conducteur électroluminescent.

5. Le dispositif semi-conducteur électroluminescent selon la revendication 3, dans lequel la zone de modification est formée à une position au moins 30µm espacée de la surface supérieure du substrat comportant une structure de nitrure.

6. Le dispositif semi-conducteur électroluminescent selon la revendication 3, dans lequel quand la au moins une zone de modification comprend une pluralité de zones de modification, les zones de modification sont espacées les unes des autres avec un intervalle de 40 ~ 90 µm.

7. Le dispositif semi-conducteur électroluminescent selon la revendication 4, dans lequel le laser est un laser pulsé de type femto-seconde ou pico-seconde utilisant une source infrarouge.

8. Le dispositif semi-conducteur électroluminescent selon la revendication 1, dans lequel la structure émettrice de lumière comprend une couche semi-conductrice de nitrure de type n, la couche active, et une couche semi-conductrice de nitrure de type p, qui sont séquentiellement formées sur la surface supérieure du substrat en saphir, et comporte un trou qui est formé à une distance prédéterminée de la surface latérale de la structure émettrice de lumière de telle sorte à exposer une partie d'une surface supérieure de la couche semi-conductrice de nitrure de type n, et
la structure émettrice de lumière comprend en outre une électrode de type n formée sur la surface supérieure da la couche semi-conductrice de nitrure de type n exposée par le trou.

9. Un procédé de fabrication d'un dispositif semi-conducteur électroluminescent, comprenant:
une formation d'une structure émettrice de lumière comprenant une pluralité de couches épitaxiales de nitrure comprenant une couche active qui produit de la lumière sur une surface supérieure d'un substrat en saphir;
un enlèvement d'une région partiale de la structure émettrice de lumière de telle manière à exposer une région prédéterminée du substrat en saphir; et
une gravure humide d'une surface latérale de la structure émettrice de lumière définie par la région exposée du substrat en saphir, de telle manière à former une surface inclinée qui crée un angle aigu par rapport à la surface supérieure du substrat en saphir et former des rainures dans la surface inclinée dans une direction perpendiculaire,
dans lequel les rainures augmentent le rendement d'extraction de lumière dans une direction latérale de la structure émettrice de lumière.

10. Le procédé selon la revendication 9, comprenant en outre la séparation du substrat en saphir dans des dispositifs discrets unitaires de telle manière à former des dispositifs semi-conducteurs électroluminescents discrets.

11. Le procédé selon la revendication 10, dans lequel la formation des dispositifs semi-conducteurs électroluminescents discrets est réalisée de telle manière qu'un laser qui est focalisé sur au moins une hauteur dans le substrat en saphir est émis à plusieurs reprises à un intervalle prédéterminé le long d'une surface de séparation ou les dispositifs discrets sont séparés de la surface supérieure ou de la surface inférieure du substrat en saphir, de telle manière à diviser le substrat en saphir.

12. Le procédé selon la revendication 11, dans lequel la hauteur du laser focalisé est une position espacée de au moins 30µm de la surface supérieure du substrat en saphir comprenant la pluralité de couches épitaxiales de nitrure.

13. Le procédé selon la revendication 11, dans lequel quand la au moins une hauteur du laser focalisé comprend une pluralité de hauteurs, les hauteurs sont positionnées séparées pas un intervalle de 40 ~ 90 µm.

14. Le procédé selon la revendication 11, dans lequel le laser est un laser pulsé de type femto-seconde ou pico-seconde utilisant une source infrarouge.

15. Le procédé selon la revendication 9, dans lequel un motif irrégulier est formé sur la surface supérieure du substrat en saphir.

16. Le procédé selon la revendication 9, dans lequel l'enlèvement de la région partiale de la structure émettrice de lumière est réalisé en utilisant une gravure sèche ou par irradiation laser.

17. Le procédé selon la revendication 9, dans lequel la formation de la structure émettrice de lumière est réalisée en formant séquentiellement une couche semi-conductrice de nitrure de type n, la couche active, et une couche semi-conductrice de nitrure de type p sur la surface supérieure du substrat en saphir, de telle manière à former la structure émettrice de lumière, et comprenant en outre l'enlèvement d'une partie de la couche active et de la couche semi-conductrice de nitrure de type p à une position espacée de la surface latérale de la structure émettrice de lumière de telle manière à exposer une partie de la surface supérieure de la couche semi-conductrice de nitrure de type n, de telle manière à former un trou, et former une électrode de type n sur la surface supérieure de la couche semi-conductrice de nitrure de type n exposée par le trou.
